Europäisches Patentamt

European Patent Office

Office européen des brevets

(11) Veröffentlichungsnummer: **0 217 064 B1**

# EUROPÄISCHE PATENTSCHRIFT

(45) Veröffentlichungstag der Patentschrift: **23.12.92**

(51) Int. Cl.5: **H01L 37/02**, H01L 41/22, B23K 26/06

(21) Anmeldenummer: **86110753.0**

(22) Anmeldetag: **04.08.86**

(54) **Herstellung auf beiden Seiten einer Polymerfolie zu erzeugender metallischer Elektrodenstrukturen.**

(30) Priorität: **09.09.85 DE 3532107**

(43) Veröffentlichungstag der Anmeldung:
**08.04.87 Patentblatt 87/15**

(45) Bekanntmachung des Hinweises auf die Patenterteilung:
**23.12.92 Patentblatt 92/52**

(84) Benannte Vertragsstaaten:
**AT CH DE FR GB IT LI**

(56) Entgegenhaltungen:
**GB-A- 1 155 272**
**US-A- 3 657 510**
**US-A- 3 989 778**
**US-A- 4 128 752**

**NEUE VERPACKUNG, Band 33, Nr. 1, Januar 1980, Seite 28, Heidelberg, DE; "Markieren von Schokoladeetiketten mit Laserstrahlen"**

**PATENTS ABSTRACTS OF JAPAN, Band 8, Nr. 128 (M-302)[1565], Juni 1984; & JP-A-59 30 494 (TOKYO SHIBAURA DENKI K.K.) 18-02-1984**

(73) Patentinhaber: **SIEMENS AKTIENGESELL-SCHAFT**
**Wittelsbacherplatz 2**
**W-8000 München 2(DE)**

(72) Erfinder: **Meixner, Hans, Dr. Dipl.-Phys.**
**Max-Planck-Strasse 5**
**W-8013 Haar(DE)**
Erfinder: **Freitag, Reinhard, Dipl.-Ind.**
**Milbertshofener Strasse 131**
**W-8000 München 40(DE)**
Erfinder: **Krimmel, Eberhard F., Dr.rer.nat.**
**Mendelssohnstrasse 7**
**W-8032 Pullach(DE)**

# Beschreibung

Aus der deutschen Patentschrift 29 30 632 (79P7106) ist ein Pyrodetektor bekannt, dessen Sensorelement als wesentlichen Bestandteil eine Folie aus PVF bzw. PVDF (Polyvenylidenfluorid) mit einer Dicke von unterhalb 20 µm hat. Diese in der genannten Patentschrift in den Figuren und der dazugehörigen Beschreibung eingehend beschriebene Folie des Sensorelementes besitzt gemäß einer bevorzugten Ausführungsform auf den beiden einander gegenüberliegenden Oberflächen dieser Folie Elektroden in der Form strukturierter Metallbelegungen. Diese Metallbelegungen bilden paarweise Elektroden, wozu entsprechende, wenigstens teilweise deckungsgleiche Anordnung der jeweiligen Elektrodenstrukturen auf beiden Seiten erforderlich ist.

Es bieten sich eine Reihe von Verfahren an, diese einzelnen Elektrodenstrukturen auf den beiden Folienoberflächen anzubringen. Beispielsweise kann die Elektrodenstruktur der jeweiligen Seite durch einzelnes maskiertes Aufdampfen des Metalls dieser Struktur erzeugen. Um die geforderte Deckungsgleichheit der beiden Elektrodenstrukturen zu erzielen, ist entsprechende Einhaltung der Toleranzen erforderlich. Im wesentlichen gleiches gilt für ein Herstellungsverfahren der Strukturen, bei dem die jeweilige eine Oberfläche der Folie metallisiert wird und dann die jeweils vorgegebene Struktur in dieser Metallisierungsschicht in einem zweiten Schritt erzeugt wird. Für diesen zweiten Schritt kann z.B. ein durch Wärmeeinwirkung zu erzielendes Abtragen von Anteilen der Metallisierungsfläche benutzt werden.

Einem Verfahren der mit Wärmeeinwirkung durchzuführenden Abtragung steht an sich die Befürchtung entgegen, es wäre unvermeidlich, daß dabei die sehr dünne Polymerfolie erheblichen Schaden nehmen könnte bzw. daß eine solche Maßnahme erheblichen technologischen Aufwand, insbesondere hinsichtlich exakter Dosierung erfordert, so daß ein derartiges Verfahren für die Herstellung eines Massenproduktes nicht in Betracht kommen kann.

Aus der US-A-3 989 778 ist ein Verfahren zum miteinander Verschweißen von thermoplastischem Material bekannt. Wie beim üblichen Punktschweißen wird anstelle einer von oben zugeführten und von unten zugeführten Elektrode jeweils ein Laserstrahl auf das Material gerichtet. Die Strahlung eines $CO_2$-Lasers, dessen Strahlung sich für das Schweißen von Kunststoffmaterial besonders eignet, wird für diesen Zweck in zwei solche von oben und von unten auf das Material gerichtete Teilstrahlen aufgeteilt. Mit dem Auftreffen dieser Teilstrahlen wird das Material örtlich zum Schmelzen und zur Verbindung miteinander gebracht.

Die GB-A-1 155 272 beschreibt die Verwendung eines Lasers zum Markieren von Glas bzw. zur Herstellung einer optischen Gitterstruktur in der Glasoberfläche. Da das Glas als solches Laserstrahlung nicht absorbiert, ist eine zusätzliche absorbierende Hilfsschicht auf das Glas aufgebracht worden. Nach der Durchführung der Markierung wird noch nicht ohnehin verbranntes Material der Absorbtionsschicht durch Polieren entfernt.

Die US-A-3 657 510 beschreibt den Einsatz eines gepulsten Lasers zur Oberflächenbehandlung bestimmter Kunststoffe.

Es ist eine Aufgabe der vorliegenden Erfindung, für das oben beschriebene Problem bzw. für die Elektrodenbeschichtung der Polymerfolie eines wie oben angegebenen Pyrodetektors solche Maßnahmen anzugeben, die einerseits technisch wenig aufwendig sind und andererseits zuverlässiges Ergebnis erzielen lassen.

Diese Aufgabe wird mit den Merkmalen des Patentanspruches 1 gelöst und weitere Ausgestaltungen und Weiterbildungen der Erfindung gehen aus den Unteransprüchen hervor.

Der Erfindung liegen einzelne, an sich zueinander unzusammenhängende Gedanken zugrunde, die jedoch bei Kombination miteinander ein überraschendes Ergebnis erzielen lassen. So ist es mit dem gleichzeitig beidseitigen, maskierten Strukturieren der Folienoberflächen möglich, hohe Deckungsgleichheit zu erzielen. Bei der Erfindung ist die Justierung und damit der hierfür nur einmal zu betreibende Aufwand in das Bestrahlungssystem verlegt. Die impulsförmige Strahlungseinwirkung und insbesondere die spezielle Bemessung der Impulse gewährleistet nicht nur, daß schädliche Einwirkungen auf das Material der Folie ausgeschlossen sind. Dabei ist zu beachten, daß die Materialeigenschaften der Folie für das Funktionieren des Pyrodetektors ganz entscheidend sind. Die kurze Pulsdauer gewährleistet nämlich, und zwar zusammen mit der gleichzeitig beidseitigen Bestrahlung der Folie, daß ein Momentanprozeß abläuft. Dieser Momentanprozeß hat den weiteren Vorteil, daß der zur erfindungsgemäßen Herstellung der Elektrodenstrukturen verwendeten Vorrichtung die betreffende Folie nicht in Form einzelner Blätter zugeführt werden muß. Es kann nämlich vorteilhafterweise das Folienmaterial als Band durch die Vorrichtung durchlaufen. Das Folienband hat zu diesem Zeitpunkt bereits auf beiden Oberflächenseiten eine ganzflächige Metallisierungsbelegung. Diese beidseitige Metallisierung kann im übrigen in einer vorangehenden Stufe dieses Durchlaufes durch die Vorrichtung aufgebracht werden. Bei erfindungsgemäß in der Größenordnung von 20 ns langen Impulsen und bei einer in Bandlaufrichtung bemessenen Länge von 10 mm der für jeweils ein Sensorelement eines Pyrodetektors erforderlichen Einzelfolie kann man das Band z.B. mit einer Geschwindigkeit von bis zu 1 cm/s laufen lassen und man erzielt dennoch kantenscharfe, genügend deckungsgleiche, beidseitige Elektrodenstrukturen auf der Folie.

Je nach Feinheit der vorgegebenen Elektrodenstruktur, für deren Herstellung eine entsprechende Maske verwendet wird, ist entsprechend kurzwellige elektromagnetische Strahlung zu verwenden, um Störungen durch Beugung auszuschließen. Im Regelfall genügt es, wenn die Wellenlänge der verwendeten Strahlung nicht größer ist als der halbe Wert der kleinsten Strukturabmessung. Zum Beispiel für Strukturen mit einer Feinheit von 1 $\mu$m sollte die Wellenlänge der Strahlung nicht größer als 0,5 $\mu$m sein. Für die vorliegende Erfindung kommen daher bevorzugt Laser als entsprechend energiereiche Quellen elektromagnetischer Strahlung in Frage, und darunter insbesondere Excimer-Laser, z.B. mit KrF$^+$ mit 248 nm Wellenlänge und mit ArF$^+$ mit 193 nm Wellenlänge. Andere verwendbare Laser sind Rubinlaser, Alexandrit-Laser, Neodym-YAG-Laser und dgl. Mit solchen Lasern Strahlungsimpulse mit 20 ms zu erzeugen ist an sich problemlos und die Impulsfolge kann z.B. 100 Hz betragen. Excimer-Laser haben zudem den Vorzug großer Öffnung.

Eine in Frage kommende Dicke der Metallisierungsbeschichtung der Polymerfolie liegt im Bereich von einigen 10 nm. Als Material kommen insbesondere Aluminium, Silber, Gold und dgl., sowie auch Molybdän in Betracht.

Als Richtwerte für gemäß der Erfindung abgestimmte Bemessung der einwirkenden Strahlung sei von einer zu strukturierenden PVDF-Folie in Rechteckform mit Kantenlängen von 10 und 25 mm ausgegangen. Vorzugsweise werden diese 2,5 cm$^2$ mit der entsprechenden Struktur ganzflächig mittels der elektromagnetischen Strahlung bestrahlt. Die auf jeweils 1cm$^2$ Fläche bezogene, in der jeweiligen Metallisierung 2, 3 zur Absorbtion kommende Energie der Strahlung sollte für Aluminium 0,2 bis 0,6, vorzugsweise 0,4 J, betragen. Entsprechende Werte sind für: Silber 0,05 bis 0,2, vorzugsweise 0,1 J, für Gold 0,01 bis 0,3, vorzugsweise 0,2 J und für Molybdän 0,2 bis 0,5, vorzugsweise 0,3 bis 0,4 J. Die Zahlenwerte sind mit 20 ns Impulsen ermittelt. Die engeren Werte beziehen sich speziell auf 40 nm Schichtdicke der Metallisierung.

Im Rahmen der für die Erfindung angegebenen Werte ein jeweiliges Optimum zu finden, ist für den Fachmann, ausgerüstet mit der Kenntnis dieser Erfindungsbeschreibung, kein weiteres Problem mehr. Es sei darauf hingewiesen, daß die voranstehenden Zahlenwerte die absorbierte, d.h. in der jeweiligen Metallisierung zur Wirkung kommende Energie angeben und für die jeweils eine Oberfläche der Folie gelten. Es sind also für die Bemessung der aufzuwendenden Strahlungsenergie noch das jeweilige Maß der an der betreffenden Metallisierung auftretenden Reflexion und die Tatsache der gleichzeitig beidseitigen Bearbeitung der (beiden) Folienflächen zu berücksichtigen.

Mit dem Einwirken der erfindungsgemäß bemessenen elektromagnetischen Strahlung erfolgt an den durch die jeweils vorgesehene Maske nicht abgedeckten Stellen ein Verdampfen des auf der Folienoberfläche sich befindenden Metalls. Es sind mit den gegebenen Bemessungen bemerkenswert scharfe Strukturen zu erzielen, und zwar selbst bei fortlaufendem Transport des als Band durchlaufenden Folienmaterials.

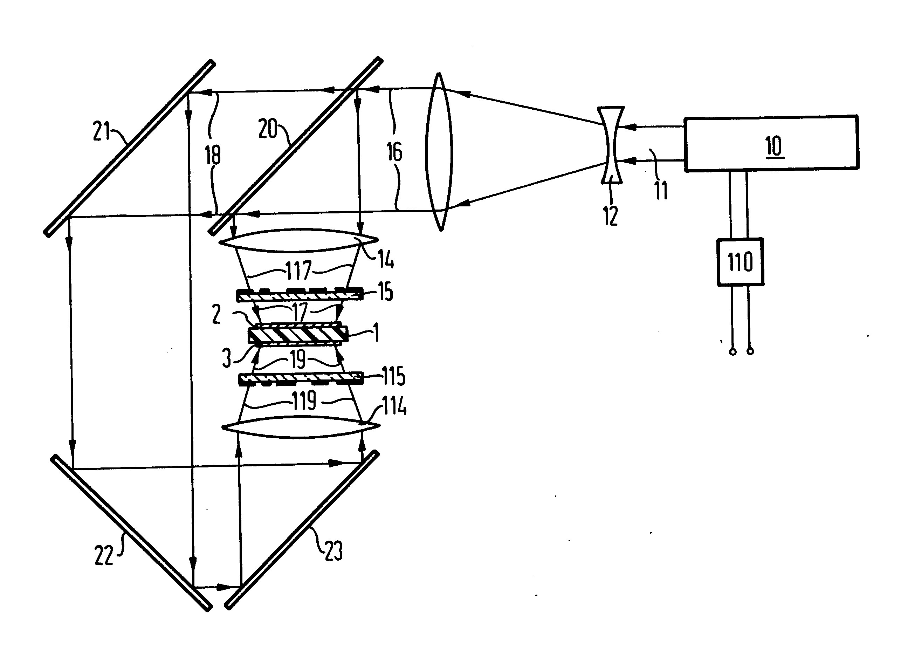

Die beigefügte Figur zeigt eine Vorrichtung zur Durchführung des erfindungsgemäßen Verfahrens. Mit 1 ist (im Schnitt) das Band der Folie bezeichnet, dessen Bewegungsrichtung senkrecht zur Darstellungsebene der Figur orientiert ist. Mit 2 und 3 sind die auf der jeweiligen Oberflächenseite des Bandes 1 aufgebrachten, ganzflächigen Metallisierungen bezeichnet. Mit 10 ist die Strahlungsquelle, insbesondere ein Laser, vorzugsweise ein Excimer-Laser bezeichnet.

Die von dieser Strahlungsquelle 10 ausgehende Strahlung 11 kann in einer fakultativ vorgesehenen Zerstreuungslinse aufgeweitet sein. Dies kann zum einen dazu dienen, die ausreichend großflächige Bestrahlung der Folie 1 zu gewährleisten. Auf der Folienoberfläche muß die Bestrahlungsfläche die gesamte vorgesehene Elektrodenstruktur des jeweils einzelnen Sensorelements des Pyrodetektors überdecken. Zum anderen kann die Strahlungsaufweitung dazu dienen, die durch die auftreffende Strahlung sich ergebende Belastung der Oberflächen der noch zu erörternden Spiegel vorteilhafterweise herabzusetzen. Mit 14 ist eine fakultativ zu verwendende Sammellinse bezeichnet. Bei der Ausführungsform der Figur sind die beiden Zwecke verfolgt.

Mit 15 ist die eine Maske bezeichnet, die die in der Metallisierungsschicht 2 zu erzeugende Strukturform enthält. Die Maske 15 ist eine vorzugsweise aus Glas bestehende Platte mit der Elektrodenstruktur entsprechenden Maskierung.

Diese Maske 15 (und ebenso die Maske 115) kann eine "Kontakt"-Maske sein, mit der die Struktur im wesentlichen 1:1 auf die Folie 1 übertragen wird. Sie kann auch eine Projektionsmaske mit (im Regelfall verkleinernder) Übertragung der Struktur sein. Es empfiehlt sich jedoch in beiden Fällen noch genügend Abstand zwischen der Maske und der Folie einzuhalten, so daß verdampfendes Material der Metallisierungsschicht die Maske nicht wesentlich verschmutzt.

Die Strahlung 16 wird an einem halbdurchlässigen Spiegel 20 zum entsprechenden Anteil reflektiert und gelangt durch (die fakultativ vorgesehene Linse 14 und durch) die Maske 15 als Strahlung 17 auf bzw. in die Metallisierungsschicht 2.

Durch den halbldurchlässigen Spiegel 20, der insbesondere ein Interferenzspiegel ist, hindurchgetretene Strahlung 18 wird durch weitere entsprechende Spiegel 21, 22 und 23 derart umgelenkt, daß sie auf die Metallisierung 3 der gegenüberliegenden Oberflächenseite der Folie 1 gelangt.

Es wird z.B. eine der Linse 14 entsprechende Linse 114 vorgesehen sein. Die für die Metallisierung 3 vorgesehene Maske 115 enthält die in der Metallisierung 3 zu erzeugende Strukturierung. Nach Durchtritt durch die Strukturierung der Maske 115 trifft die Strahlung 19 auf die Metallisierung 3. Mit 117 und 119 sind die jeweiligen Strahlungsanteile vor Durchtritt durch die Masken 15, 115 bezeichnet.

Die Strahlungsquelle 10 wird mit Hilfe einer entsprechenden elektronischen Einrichtung 110 gesteuert und der Impuls der Strahlung 17 bzw. 19 erzeugt in der Metallisierung 2 bzw. in der Metallisierung 3 die vorgegebene Struktur.

Infolge des in der Durchführung des Verfahrens unverändert bleibenden Aufbaues der Vorrichtung entfällt nicht nur Exemplarstreuung der hergestellten, mit beidseitigen Elektrodenstrukturen versehenen Folieelemente, sondern es ist auch die oben erwähnte Deckungsgenauigkeit gewährleistet.

## Patentansprüche

1. Verfahren mit dem auf beiden Seiten einer dünnen, pyroelektrischen Polymerfolie metallische Elektrodenstrukturen mit hoher Deckungsgleichheit erzeugt werden,
   **gekennzeichnet dadurch,**
   - daß die aus einer jeweils ganzflächigen Metallisierung 2, 3) der beiden Oberflächen der Polymerfolie (1) der Elektrodenstruktur entsprechenden, zu entfernenden Anteile mittels energiereicher Strahlung (17, 19) eines Excimer-, Neodym-YAG-, Rubin- oder Alexandrit- Lasers (10) weggedampft werden,
   - daß man von nur einer Strahlungsquelle (10) ausgeht, deren Strahlung man aufgeteilt (17-19) auf die jeweilige der beiden Oberflächenseiten der Folie (1) einwirken läßt,
   - daß man die Strahlung (17, 19) durch je eine im Bestrahlungssystem justierte, entsprechend strukturierte Maske (15 bzw. 115) hindurch impulsweise (110) einwirken läßt
   - und daß mit der Strahlung (117, 119) momentan die jeweils gesamte zu strukturierende Fläche der jeweiligen Metallisierung (2, 3) bestrahlt wird.

2. Verfahren nach Anspruch 1, **gekennzeichnet** dadurch, daß ein Excimer-Laser (10) verwendet wird.

3. Verfahren nach Anspruch 1 oder 2, **gekennzeichnet** dadurch, daß man das Material der Folie (1) als Band zwischen den justierten Masken (15, 115) hindurchlaufen läßt.

4. Verfahren nach Anspruch 3, daß man das Band der Folie (1) kontinuierlich hindurchlaufen läßt.

5. Verfahren nach einem der Ansprüche 1 bis 4, **gekennzeichnet dadurch,** daß Strahlungsimpulse einer Dauer von 10 bis 30 ns erzeugt werden und die in der jeweiligen Metallisierung (2, 3) zur Absorbtion kommende Strahlungsenergie 0,05 bis 0,6 J pro $cm^2$-Oberfläche beträgt.

6. Verfahren nach Anspruch 5, **gekennzeichnet dadurch,** daß für Aluminium als Metallisierung (2, 3) diese flächenspezifische Strahlungsenergie 0,2 bis 0,6 J beträgt.

7. Verfahren nach Anspruch 5, **gekennzeichnet dadurch,** daß für Silber als Metallisierung (2, 3) diese flächenspezifische Strahlungsenergie 0,05 bis 0,2 J beträgt.

8. Verfahren nach Anspruch 5, **gekennzeichnet dadurch,** daß für Gold als Metallisierung (2, 3) diese flächenspezifsche Strahlungsenergie 0,01 bis 0,3 J beträgt.

9. Verfahren nach Anspruch 5, **gekennzeichnet dadurch,** daß für Molybdän als Metallisierung (2, 3) diese flächenspezifische Strahlungsenergie 0,2 bis 0,5 J beträgt.

10. Verfahren nach Anspruch 5, **gekennzeichnet dadurch,** daß für Aluminium als Metallisierung (2, 3) diese flächenspezifische Strahlungsenergie 0,4 J beträgt.

11. Verfahren nach Anspruch 5, **gekennzeichnet dadurch,** daß für Silber als Metallisierung (2, 3) diese flächenspezifische Strahlungsenergie 0,1 J beträgt.

12. Verfahren nach Anspruch 5, **gekennzeichnet dadurch,** daß für Gold als Metallisierung (2, 3) diese flächenspezifische Strahlungsenergie 0,17 J beträgt.

**13.** Verfahren nach Anspruch 5, **gekennzeichnet dadurch,** daß für Molybdän als Metallisierung (2, 3) diese flächenspezifische Strahlungsenergie 0,3 bis 0,4 J beträgt.

## Claims

**1.** Method by which metallic electrode structures are produced on both sides of a thin pyroelectric polymer film with a high degree of congruence, characterised in that the portions to be removed from an in each case full-area metallisation (2, 3) of the two surfaces of the polymer film (1), corresponding to the electrode structure, are vaporised away by means of high-energy radiation (17, 19) of an excimer, neodymium-YAG, ruby or alexandrite laser (10), in that use is made of only one radiation source (10), the radiation of which is divided (17-19) before being allowed to act on the respective side of the two surface sides of the film (1), in that the radiation (17, 19) is allowed to act pulsewise (110) through a mask in each case (15 and 115 respectively), which is adjusted in the irradiation system and is correspondingly structured, and in that at any one instant the entire area of the respective metallisation (2, 3) to be structured in each case is irradiated with the radiation (117, 119).

**2.** Method according to Claim 1, characterised in that an excimer laser (10) is used.

**3.** Method according to Claim 1 or 2, characterised in that the material of the film (1) is allowed to run through as a band between the adjusted masks (15, 115).

**4.** Method according to Claim 3, characterised in that the band of the film (1) is allowed to run through continuously.

**5.** Method according to one of Claims 1 to 4, characterised in that radiation pulses of a duration of 10 to 30 ns are generated and the radiation energy which is absorbed in the respective metallisation (2, 3) is 0.05 to 0.6 J per cm$^2$ of surface area.

**6.** Method according to Claim 5, characterised in that, for aluminium as metallisation (2, 3), this area-specific radiation energy is 0.2 to 0.6 J.

**7.** Method according to Claim 5, characterised in that, for silver as metallisation (2, 3), this area-specific radiation energy is 0.05 to 0.2 J.

**8.** Method according to Claim 5, characterised in that, for gold as metallisation (2, 3), this area-specific radiation energy is 0.01 to 0.3 J.

**9.** Method according to Claim 5, characterised in that, for molybdenum as metallisation (2, 3), this area-specific radiation energy is 0.2 to 0.5 J.

**10.** Method according to Claim 5, characterised in that, for aluminium as metallisation (2, 3), this area-specific radiation energy is 0.4 J.

**11.** Method according to Claim 5, characterised in that, for silver as metallisation (2, 3), this area-specific radiation energy is 0.1 J.

**12.** Method according to Claim 5, characterised in that, for gold as metallisation (2, 3), this area-specific radiation energy is 0.17 J.

**13.** Method according to Claim 5, characterised in that, for molybdenum as metallisation (2, 3), this area-specific radiation energy is 0.3 to 0.4 J.

## Revendications

**1.** Procédé par lequel on produit, avec une grande uniformité de recouvrement, sur les deux faces d'une feuille mince de polymère pyroélectrique, des structures métalliques d'électrodes, caractérisé en ce qu'il consiste :
   - à enlever par évaporation, au moyen d'un rayonnement (17, 19) riche en énergie d'un laser excimère à néodyme-YAG, à rubis ou à alexandrite, les parties à éliminer et correspondant à la structure des électrodes, d'une métallisation (2, 3) sur toute la surface des deux faces de la feuille de polymère (1),
   - à n'émettre que d'une source de rayonnement (10) dont on fait agir le rayonnement de manière séparée (17-19), sur les deux faces de la feuille (1),
   - à faire agir le rayonnement (17, 19) par impulsion (110), à travers un masque (15 et 115) structuré de manière adéquate et ajusté dans le système d'exposition,
   - et à exposer au rayonnement (117, 119) temporairement toute la surface à structurer de chaque métallisation (2, 3).

**2.** Procédé suivant la revendication 1, caractérisé en ce qu'il consiste à utiliser un laser excimère (10).

**3.** Procédé suivant la revendication 1 ou 2, caractérisé en ce qu'il consiste à faire passer le matériau de la feuille (1) en tant que bande entre les masques (15, 115) ajustés.

4.  Procédé suivant la revendication 3, qui consiste à faire passer la bande de feuille (1) en continu.

5.  Procédé suivant l'une des revendications 1 à 4, caractérisé en ce qu'il consiste à produire une impulsion de rayonnement d'une durée de 10 à 30 ns et en ce que l'énergie de rayonnement venant dans chaque métallisation (2, 3) pour l'absorption est comprise entre 0,05 et 0,6 J par $cm^2$ de surface.

6.  Procédé suivant la revendication 5, caractérisé en ce que, pour de l'aluminium comme métallisation (2, 3), cette énergie de rayonnement spécifique est de 0,2 à 0,6 J par unité de surface.

7.  Procédé suivant la revendication 5, caractérisé en ce que, pour de l'argent comme métallisation (2, 3), cette énergie de rayonnement spécifique est de 0,05 à 0,2 J par unité de surface.

8.  Procédé suivant la revendication 5, caractérisé en ce que, pour de l'or comme métallisation (2, 3), cette énergie de rayonnement spécifique est comprise entre 0,01 et 0,3 J par unité de surface.

9.  Procédé suivant la revendication 5, caractérisé en ce que, pour du molybdène comme métallisation (2, 3), cette énergie de rayonnement spécifique est de 0,2 à 0,5 J par unité de surface.

10. Procédé suivant la revendication 5, caractérisé en ce que, pour de l'aluminium comme métallisation (2, 3), cette énergie de rayonnement spécifique est de 0,4 J par unité de surface.

11. Procédé suivant la revendication 5, caractérisé en ce que, pour de l'argent comme métallisation (2, 3), cette énergie de rayonnement spécifique est de 0,1 J par unité de surface.

12. Procédé suivant la revendication 5, caractérisé en ce que, pour de l'or comme métallisation (2, 3), cette énergie de rayonnement spécifique est de 0,17 J par unité de surface.

13. Procédé suivant la revendication 5, caractérisé en ce que, pour du molybdène comme métallisation (2, 3), cette énergie de rayonnement spécifique est comprise entre 0,3 et 0,4 J par

unité de surface.

EP 0 217 064 B1